# FASCICULE DE BREVET EUROPEEN

(11) **EP 0 474 567 B1**
(45) Date de publication et mention de la délivrance du brevet: **20.12.1995**
(21) Numéro de dépôt: 91420296.5
(22) Date de dépôt: 14.08.1991
(51) Int. Cl.: H03M 1/14, H03M 1/36

(54) **Convertisseur analogique/numérique à interpolation**
Interpolierender Analog-Digitalwandler
Interpolating analog-digital converter

(30) Priorité: 21.08.1990 FR 9010739
(43) Date de publication de la demande: 11.03.1992
(73) Titulaire: SGS-THOMSON MICROELECTRONICS S.A., 94250 Gentilly (FR)
(72) Inventeur: Mouret, Michel, F-38560 Jarry (FR)
(74) Mandataire: de Beaumont, Michel

(56) Documents cités:
- US-A- 4 599 602
- IEEE JOURNAL OF SOLID-STATE CIRCUITS vol. SC-22, no. 6, 6 Décembre 1987, pages 944 - 953; R.E.J. VAN DE GRIFT ET AL.: 'An 8-bit video ADC incorporating folding and interpolation techniques'

## Description

La présente invention concerne le domaine des convertisseurs analogique/numérique rapides et plus particulièrement les convertisseurs analogique/numérique du type à interpolation.

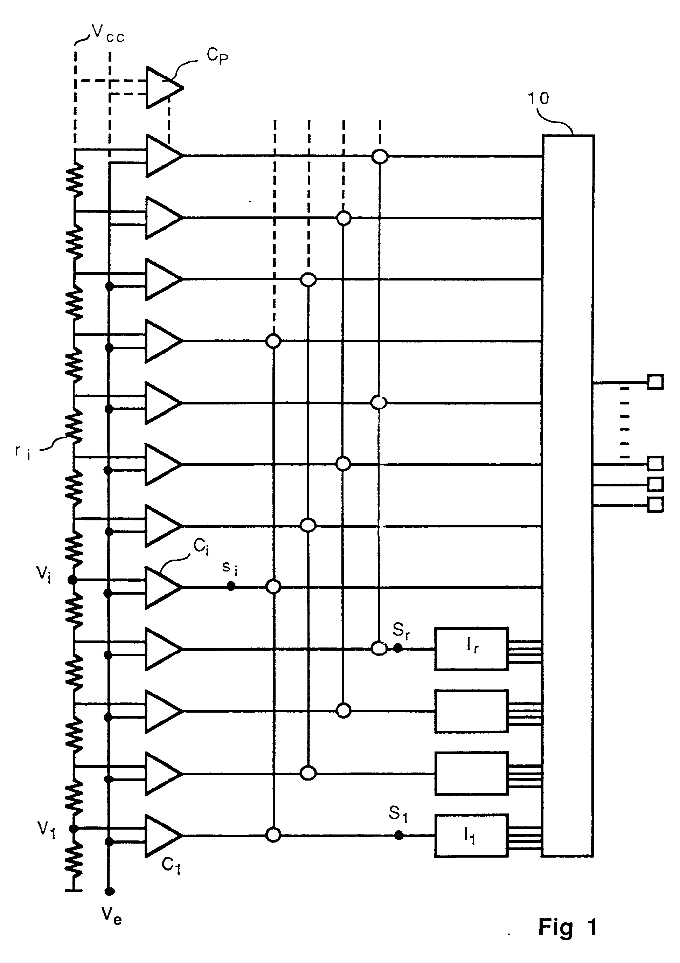

La figure 1 illustre très schématiquement l'organisation générale d'un convertisseur analogique/numérique à interpolation à N bits.

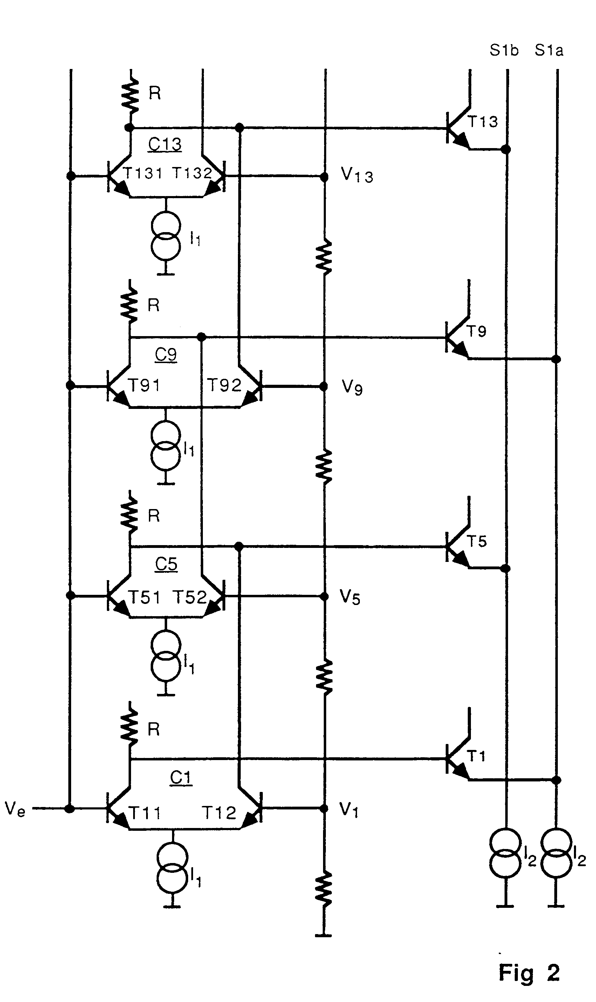

La grandeur analogique d'entrée Vₑ est comparée dans p comparateurs d'entrée C₁... Cᵢ...Cₚ à des tensions de référence fournies par exemple par un pont de résistance étagées rᵢ. Les tensions de sortie sᵢ des comparateurs Cᵢ sont combinées en r groupes : la sortie sᵢ du comparateur Cᵢ avec les sorties Sᵢ₋ᵣ, sᵢ₋₂ᵣ... et sᵢ₊ᵣ, sᵢ₊₂ᵣ... et de même la sortie sᵢ₊₁ du comparateur Cᵢ₊₁ avec les sorties sᵢ₊₁₊ᵣ, sᵢ₊₁₊₂ᵣ, ..., et sᵢ₊₁₋ᵣ, sᵢ₊₁₋₂ᵣ..., etc., pour fournir des sorties combinées S₁...Sᵣ. Chacune des r sorties combinées S₁...Sᵣ résulte d'un repliement comme cela sera explicité en relation avec la figure 2, et est ensuite appliquée à r circuits d'interpolation I₁...Iᵣ dont chacun réalise une interpolation en q+1 sous-intervalles de tension dont chacun correspond à la division par q+1 de l'intervalle entre les tensions de référence appliquées à deux comparateurs Cᵢ successifs. Les sorties sᵢ des comparateurs Cᵢ et les sorties des interpolateurs I₁ à Iᵣ sont appliquées à un circuit de mémorisation et de codage 10 pour fournir sur des conducteurs de sortie une valeur numérique correspondant à l'amplitude du signal analogique d'entrée. Un tel convertisseur est par exemple décrit dans "An 8-bit 50 MHz Video ADC with folding and interpolation techniques", R Van de Grift et al, PP. 94-95, ISSCC 87.

Avec p comparateurs d'entrée et q interpolations, on réalise un convertisseur analogue/numérique à N bits tel que 2^{N} = p(q+1) en réduisant le nombre total des comparateurs qui, au lieu d'être égal à 2^{N} est égal à p (comparateurs d'entrée) + r(q+1) (comparateur d'interpolation). Etant donné que r est généralement relativement faible, ceci conduit, dès que le nombre, N, de bits du convertisseurs analogique/numérique devient élevé, par exemple supérieur à 8, à réduire notablement le nombre de comparateurs d'entrée, cette réduction du nombre de comparateurs d'entrée étant bien supérieur au nombre de comparateurs supplémentaires nécessaires dans les r circuits d'interpolation.

La figure 2 représente un exemple classique de réalisation et d'association de comparateurs successifs d'un même groupe parmi les r groupe de comparateurs. On a supposé que r était égal à 4 et l'on peut voir en figure 2 les comparateurs successifs C₁, C₅, C₉, C₁₃... Chaque comparateur comprend dans l'exemple illusté deux transistors NPN sont les émetteurs sont reliés ensemble et à la masse par l'intermédiaire d'une source de courant I1. La base du premier transistor reçoit la tension d'entrée et la base du deuxième transistor reçoit la tension de référence correspondant à ce comparateur. Le collecteur du premier transistor (T₁₁, T₅₁, T₉₁, T₁₃₁) de chacun des comparateurs est relié à une borne d'alimentation haute par l'intermédiaire d'une résistance R et le signal sur ce collecteur est recopié par un transistor NPN (T₁, T₅, T₉, T₁₃...) dont le collecteur est relié à une source de tension haute et l'émetteur constitue la borne de sortie S₁. En fait, on a représenté deux lignes de sortie S₁ₐ et S_{1b} connectées à la masse par des sources de courant I₂ dont chacune est reliée à un transistor sur deux, de sorte que l'on obtient sur les lignes S₁ₐ et S_{1b} des signaux quasicomplémentaires. Le collecteur du deuxième transistor (T₁₂, T₅₂, T₉₂, T₁₃₂) de chacun des comparateurs est relié au collecteur du premier transistor du comparateur suivant. Ainsi, le collecteur du deuxième transistor T12 du comparatuer C₁ est relié au collecteur du premier transistor T51 du comparateur C₅ ... .

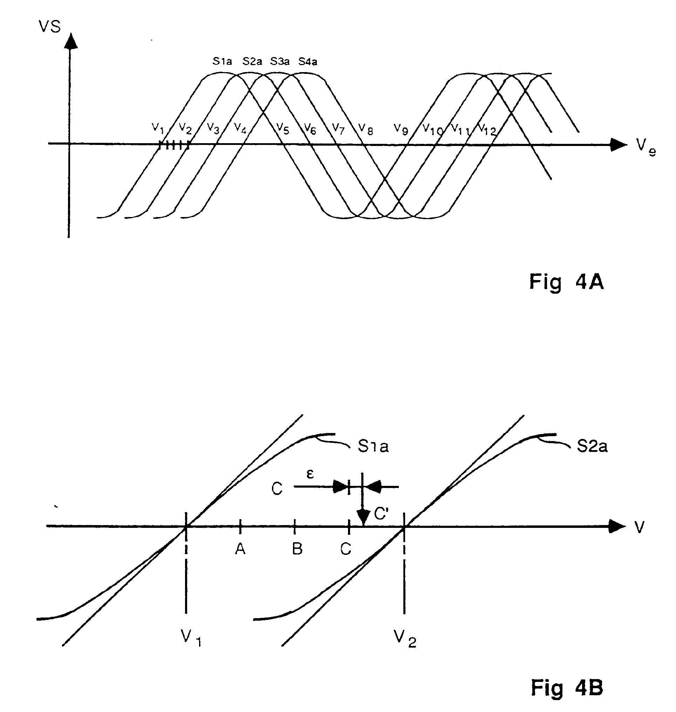

La figure 3 représente l'évolution du signal S₁ₐ en fonction de la tension d'entrée Vₑ.

Quand Vₑ est inférieur à V₁, les transistor T₁₁, T₅₁, T₉₁, T₁₃₁ sont bloqués tandis que les transistors T₁₂, T₅₂, T₉₂ T₁₃₂ sont passant. Le transistor T₁₁ étant bloqué, le transistor T₁ a sa base au potentiel haut, amenant la ligne S₁ₐ à haut niveau. Par contre, les transistors T₅, T₁₃,... dont les bases sont à bas niveau du fait de l'état passant des transistors T₁₂, T₅₂, T₉₂... imposent un niveau bas sur la ligne S_{1b}.

Quand la tension Vₑ est comprise entre V₁ et V₅, le transistor T₁₁ est passant. La base du transistor T₁ est donc à un niveau bas. Les transistors T₁₂ et T₅₁ sont faiblement conducteurs, la base du transistor T₅ est donc à un niveau haut et c'est la ligne S_{1b} qui passe à haut niveau et les bases des transistors T₅₂, T₉₂, T₁₃₂... restent à bas niveau. Ainsi, à l'exception de celle du transistor T₅, toutes les bases des transistors T₁, T₉, T₁₃... sont à un niveau bas et la ligne S₁ₐ alterne de bas à haut niveau tandis que la tension Vₑ croît. Au voisinage de chacune des tensions V₁, V₅, V₉, V₁₃..., le signal change d'état. C'est dans cette zone qu'est effectuée l'interpolation.

Cette interpolation sera de préférence réalisée en utilisant le signal S₁ₐ et son signal quasicomplémentaire S_{1b}.

En supposant toujours que r égales 4, c'est-à-dire qu'il existe quatre sorties S₁, S₂, S₃ et S₄ des comparateurs d'entrée qui sont appliquées aux circuits d'interpolation I₁...I₄, la figure 4A représente l'allure de ces sorties S₁ et S₄ et plus particulièrement des sorties S₁ₐ à S₄ₐ et la figure 4B représente l'allure des courbes S₁ₐ et S₂ₐ au voisinage des tensions V₁ et V₂. C'est au voisinage de ces changements d'état que l'on réalisera les interpolations dans les interpolateurs I₁...Iᵣ. Toutefois, l'étage différentiel utilisé, tel qu'illustré en figure 2 est fortement non-linéraire. Il est résulte d'une part que les tensions V₁ et V₂ ne doivent pas être trop écartées et que l'on ne peut pas multiplier le nombre de points d'interpolation, le nombre 4 susmentionné semblant être un maximum.

Or, il apparaît que, si l'on veut réduire le nombre de comparateurs, et donc la surface et la consommation d'un convertisseur analogique/numérique, il conviendrait, quand le nombre de bits que l'on souhaite obtenir est élevé, par exemple égal à 10, d'augmenter le nombre de niveaux d'interpolation par interpolateur.

Selon la présente invention, il est apparu que ceci pouvait être réalisé en choisissant de modifier les comparateurs/ combinateurs d'entrée pour obtenir une caractéristique linéaire de chacun de ces comparateurs/combinateurs.

Plus particulièrement, la présente invention prévoit un convertisseur analogique/numérique à interpolation à N bits comprenant un premier étage de p comparateurs dont les sorties sont associées par groupes de comparateurs décalés d'un incrément r donné, la sortie combinée de chaque groupe ayant la forme d'un signal variant périodiquement entre des niveaux haut et bas, les tensions de sortie de chaque groupe étant comparées au voisinage de leur transition dans les deuxièmes étages de q+1 comparateurs chacun (p[q+1] = 2^{N}). Chaque comparateur du premier étage est un comparateur à haute linéarité comprenant deux branches comprenant chacune un premier et un deuxième transistor, la base du deuxième transistor de chaque branche étant reliée au point de jonction des transistors de l'autre branche par l'intermédiaire d'un moyen de décalage de tension, et les émetteurs des deuxièmes transistors de chaque branche étant interconnectés par une résistance.

Ces objets, caractéristiques et avantages ainsi que d'autre de la présente invention seront exposés plus en détail dans la description suivant de modes de réalisation particuliers faite en relation avec les figures jointes parmi lesquelles :
La figure 1, décrite précédemment, représente l'architecture générale d'un convertisseur analogique/numérique à interpolation classique ;
La figure 2, décrite précédemment, représente un exemple de comparateurs d'entrée associés à un circuit combinatoire de repliement utilisé classiquement dans des circuits du type de celui de la figure 1 ;
la figure 3, décrite précédemment, représente l'allure d'un signal replié obtenu par le circuit de la figure 2 ;
La figure 4A, décrite précédemment, représente schématiquement l'ensemble des signaux repliés obtenus aux sorties Si du circuit de la figure 1 ;
la figure 4B, décrite précédemment, représente l'allure des signaux des figure 3 et 4A, agrandis au niveau de leur changement d'état ;
le figure 5 représente un circuit selon la présente invention destiné à remplacer le circuit de l'art antérieur illustré en figure 2 ; et
la figure 6 représente un mode de réalisation particulier d'un comparateur de la figure 5.

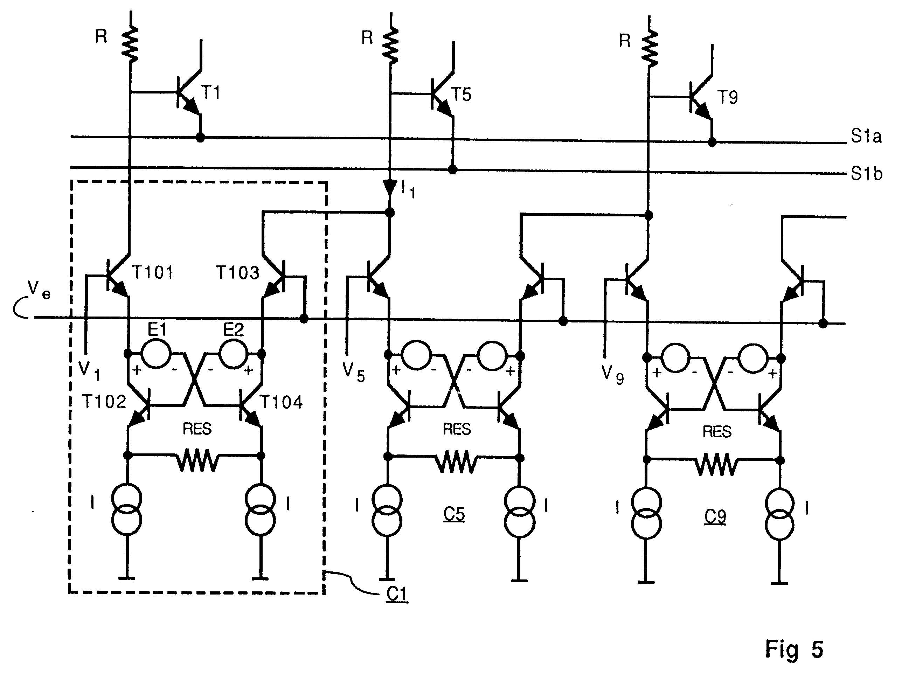

La figure 5 représente un mode de réalisation de la présente invention illustré dans un cas analogue à celui de l'art antérieur décrit précédemment en relation avec la figure 2. On y retrouve trois comparateurs C₁, C₅, C₉, des lignes de sortie complémentaires S₁ₐ et S_{1b} et des transistors de charge de ces lignes T₁, T₅, T₉...

La différence entre le circuit de la figure 5 et celui de la figure 2 réside dans la structure des comparateurs C₁, C₅, C₉. Ceux-ci sont réalisés de façon à présenter une caractéristique très linéaire au voisinage de leur région de commutation d'un état à l'autre. On va décrire ci-après de façon détaillée le comparateur C₁, les autres comparateurs étant réalisés de façon identique.

Le comparateur C₁ comprend deux branches dont chacune est connectée entre une tension haute par l'intermédiaire d'une résistance R et une tension basse par l'intermédiaire d'une source de courant I. La première branche comprend, en série, des premier et deuxième transistor NPN T₁₀₁ et T₁₀₂. De même, la deuxième branche comprend, en série, des troisième et quatrième transistor NPN T₁₀₃ et T₁₀₄. Les émetteurs des transistor T₁₀₁ et T₁₀₃ sont respectivement connectés aux collecteurs des transistors T₁₀₂ et T₁₀₄. Les émetteurs des transistors T₁₀₂ et T₁₀₄ sont interconnectés par l'intermédiaire d'une résistance RES. La base du transistor T₁₀₂ est reliée au collecteur du transistor T₁₀₄ par l'intermédiaire d'un moyen de décalage de tension E₂ et la base du transistor T₁₀₄ est reliée au collecteur du transistor T₁₀₂ par l'intermédiaire d'un moyen de décalage de tension E₁. La tension d'entrée Vₑ arrive sur la base du transistor T₁₀₃ et la tension de référence V₁ arrive sur la base du transistor T₁₀₁. Ce premier comparateur C₁ est connecté au comparateur suivant, C₅, de la façon illustrée, à savoir que le collecteur du troisième transistor d'un comparateur est relié au collecteur du premier transistor de comparateur suivant.

Le calcul montre qu'un tel comparateur est parfaitement linéaire au voisinage de sa zone de commutation, c'est-à-dire que, dans cette zone, le courant dans le collecteur du transistor T₁₀₁ est égal à I + (Vₑ-V₁)/RES.

Du fait de cette linéarité des caractéristiques, il est possible d'augmenter le nombre d'interpolations entre deux tensions de référence et donc de diminuer le nombre total de comparateurs utilisés dans le circuit. Cette réduction du nombre de comparateurs est obtenue au prix d'une augmentation de la complexité de chaque comparateur élémentaire mais l'homme de l'art notera que le bilan global est nettement en faveur de la solution proposée par l'invention.

Bien entendu, la présente invention est sujette à diverses variantes et modifications qui apparaîtront à l'homme de l'art.

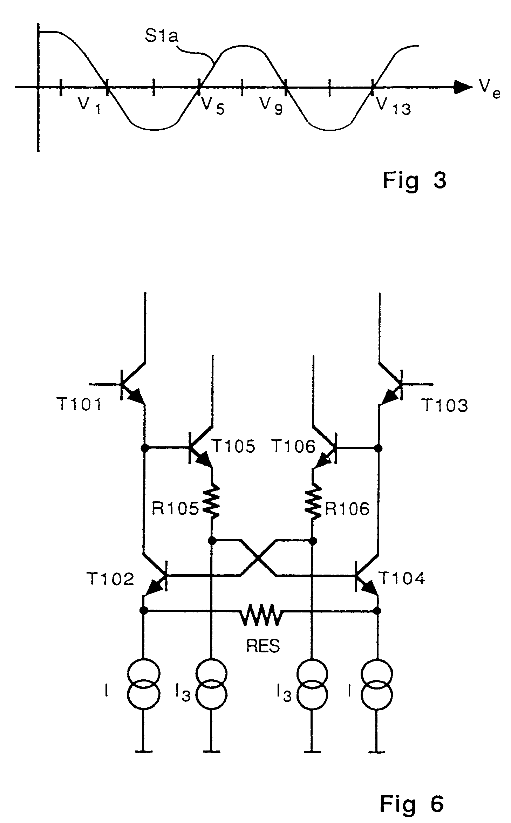

Ainsi, la figure 6 illustre un exemple de réalisation des moyens de décalage de tension E₁ et E₂ du comparateur C₁. Dans cette figure, des différences numériques identiques à celles de la figure 5 sont utilisées. Le moyen de décalage de tension E₁ comprend un transistor NPN T₁₀₅ et une résistance R₁₀₅. Le transistor T₁₀₅ est connecté en série avec la résistance R₁₀₅ et une source de courant I₃ entre la borne d'alimentation haute et la masse. La base du transistor T₁₀₅ est connectée au point de raccordement des transistor T₁₀₁ et T₁₀₂ ; la borne de la résistance R₁₀₅opposée au transistor T₁₀₅ est reliée à la base du transistor T₁₀₄. Le transistor T₁₀₆ et la résistance R₁₀₆ sont montés de façon symétrique.

## Revendications

1. Convertisseur analogique/numérique à interpolation à N bits comprenant un premier étage de p comparateurs (C₁...Cₚ) dont les sorties sont associées par groupes de comparateurs décalés d'un incrément r donné, la sortie combinée (S₁ₐ, S_{1b}) de chaque groupe ayant la forme d'un signal variant périodiquement entre des niveaux haut et bas, les tensions de sortie de chaque groupe étant comparée au voisinage de leur transition dans des deuxième étages (I₁...Iᵣ) de q+1 comparateurs chacun (p[q+1] = 2^{N}), caractérisé en ce que chaque comparateur du premier étage est un comparateur à haute linéarité comprenant deux branches comprenant chacune un premier et un deuxième transistor (T₁₀₁, T₁₀₂, T₁₀₃, T₁₀₄), la base du deuxième transistor de chaque branche étant relié au point de jonction des transistor de l'autre branche par l'intermédiaire d'un moyen de décalage de tension (E₁, E₂), et les émetteurs des deuxièmes transistors de chaque branche étant interconnectés par une résistance (RES).

## Patentansprüche

1. Interpolierender Analog-Digitalwandler mit N Bits, mit einer ersten Stufe aus p Vergleichern (C₁...Cₚ), deren Ausgänge in Gruppen von Vergleichern zusammengefaßt sind, die jeweils um ein gegebenes Inkrement r verschoben sind, wobei der gemeinsame Ausgang (S₁ₐ, S_{1b}) jeder Gruppe die Form eines Signales hat, das periodisch zwischen hohem und niedrigem Pegel variiert und die Ausgangsspannungen jeder Gruppe in der Nähe ihres Zustandswechsels in zweiten Stufen (I₁...Iᵣ) verglichen werden, die jeweils q+1 Vergleicher aufweisen (p[q+1] = 2^{N}), dadurch gekennzeichnet, daß jeder Vergleicher der ersten Stufe ein Vergleicher mit hoher Linearität ist, der zwei Zweige aufweist, von denen jeder einen ersten und einen zweiten Transistor (T₁₀₁, T₁₀₂; T₁₀₃, T₁₀₄) enthält, wobei jeweils die Basis des zweiten Transistors in jedem Zweig mit dem Verbindungspunkt der Transistoren in dem anderen Zweig über eine Einrichtung zur Spannungsverschiebung (E₁, E₂) verbunden ist und die Emitter der zweiten Transistoren in jedem Zweig miteinander über einen Widerstand (RES) verbunden sind.

## Claims

1. An N-bits interpolation analog/digital circuit comprising a first stage of p comparators (C₁...Cₚ), the outputs of which are associated by groups of comparators shifted by a determined increment r, the combined output (S₁ₐ, S_{1b}) of each group having the shape of a signal periodically varying between high and low levels, the output voltages of each group being compared close to their transition state, in second stages (I₁...Iᵣ) of q+1 comparators (p[q+1] = 2^{N}), characterized in that each comparator of the first stage is a high linearity comparator comprising two legs each comprising a first and a second transistor (T₁₀₁, T₁₀₂; T₁₀₃, T₁₀₄), the base of the second transistor of each leg being connected at the junction node of the transistors of the other leg through a voltage shifting means (E₁, E₂), and the emitters of the second transistors of each leg being interconnected through a resistor (RES).
